(19)

Europäisches
Patentamt
European
Patent Office
Office européen
des brevets

(11) **EP 4 733 817 A1**

(12) **EUROPEAN PATENT APPLICATION**

(43) Date of publication:
**29.04.2026 Bulletin 2026/18**

(21) Application number: **25209220.0**

(22) Date of filing: **16.10.2025**

(51) International Patent Classification (IPC):
**G02B 5/08** (2006.01)   **G02B 5/28** (2006.01)
**C23C 14/06** (2006.01)   **C23C 14/54** (2006.01)

(52) Cooperative Patent Classification (CPC):
**G02B 5/0833; C23C 14/0652; C23C 14/542;
C23C 14/548; G02B 5/285**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **23.10.2024 US 202418924046**

(71) Applicant: **Lockheed Martin Corporation
Bethesda, MD 20817-1877 (US)**

(72) Inventors:
 • **Dowhower, Kevie Overton
   Lompoc, 93436 (US)**
 • **Ives, Thomas Joseph
   Buellton, 93427 (US)**

(74) Representative: **Barker Brettell LLP
100 Hagley Road
Edgbaston
Birmingham B16 8QQ (GB)**

(54) **NON-DICHROIC THIN FILM COATINGS**

(57)    A non-dichroic coating thin film structure (100), consisting of a Bragg-reflector structure (130) and a graded index layer (120), is deposited on a substrate. The Bragg-reflector structure includes several pairs of layers: each pair has a first layer (131) of a first material with a first refractive index and a quarter-wavelength thickness determined by a target wavelength, positioned adjacent to a second layer (132) of a second material with a second refractive index, having a quarter-wavelength thickness. The first refractive index is at least 0.5 higher than that of the second. Over the Bragg-reflector structure (130), a graded index layer (120) with a continuously changing refractive index is deposited, transitioning from a third refractive index to the first refractive index. The thickness of the graded index layer (120) is selected such that the reflection coefficient for light in the visible spectrum of 400-700 nanometers varies by no more than 25 percent for this wavelength range.

*FIG. 1A*

EP 4 733 817 A1

## Description

### TECHNICAL FIELD

This disclosure relates to non-dichroic thin film coatings and more particularly to the thin film coatings including graded optical index layers.

### BACKGROUND

Thin films are important in many optical applications, used for controlling surface reflectance and achieving specific optical effects. These films often consist of layered structures with finely tuned optical properties to meet optical requirements. Common film structures include dielectric multilayer structures that can either enhance or reduce reflections, depending on their structure. Thin films are typically applied using advanced techniques such as physical vapor deposition (PVD) or chemical vapor deposition (CVD). These systems have detailed control features like mass flow controllers and accurate temperature settings, allowing for the precise application of thin films with specific optical qualities. This precision allows fabrication of thin films with specific optical properties for a variety of optical uses in different industries.

### SUMMARY

This disclosure introduces a novel approach using graded index composition films to effectively mask or diminish substrate coloration. This technology offers distinct advantages over conventional coating methods, addressing their inherent limitations. Applying a graded index film over substrates significantly reduces the impact of substrate color on the final appearance. By controlling the refractive index profile within the film, this technology allows for precise manipulation of light transmission and reflection properties. Consequently, undesired substrate hues are subdued, resulting in a uniform and aesthetically pleasing color across the entire coated surface.

Furthermore, the application of the graded index film can achieve non-dichroic properties for substrate color, further enhancing the visual consistency of the coated surfaces. This means the color appearance remains consistent regardless of the viewing angle.

One embodiment of this disclosure involves converting all substrate colors into various shades of gray, depending on the type of graded film used. By strategically adjusting the composition or thickness of the graded index layer, this process can facilitate transforming substrate hues into grayscale tones. Such approach not only neutralizes substrate coloration but also enhances the overall visual consistency and appeal of the coated surfaces.

A major advantage of this disclosure is its ability to achieve superior color control and consistency. By adjusting the thickness and composition of the graded index layer, variations in color perception are minimized, leading to a more uniform and visually pleasing appearance. Additionally, the tailored manipulation of light behavior allows for the realization of specific color effects desired for various applications, thus enhancing the versatility of the coated substrates.

Moreover, the graded index composition film provides an additional layer of protection for the underlying substrate, improving its durability and resistance to environmental factors. This protective function not only safeguards the integrity of the substrate but also prolongs the longevity of the coated surface, ensuring sustained aesthetic appeal over time. Combined with its optical capabilities, this aspect underscores the multifaceted benefits of employing graded index coatings in diverse industrial contexts.

The use of solid-state inorganic materials, rather than solvent-based organic paints, offers several advantages. Inorganic materials have more easily tunable optical properties and can be made more chemically and environmentally durable. Additionally, they avoid the release of volatile organic compounds, reducing environmental harm.

Other technical advantages will be readily apparent to one skilled in the art from the following figures, descriptions, and claims. Moreover, while specific advantages have been enumerated above, various embodiments may include all, some, or none of the enumerated advantages.

Consistent with various other embodiments, the appended claims may serve as a further summary of the disclosure.

Embodiments described herein relate to a non-dichroic coating thin film structure and a system for forming such a structure.

In particular non-limiting embodiments, the structure is deposited over a substrate, the non-dichroic coating thin film structure including a Bragg-reflector structure deposited over the substrate. The Bragg-reflector structure includes a plurality of pairs of layers, each pair having a first layer and a second layer. The first layer comprises a first material of a first refractive index and has a first thickness of a quarter of a target wavelength determined within the first layer, the first layer positioned adjacent to the second layer. The second layer comprises a second material of a second refractive index and has a second thickness of a quarter of the target wavelength determined within the second layer, wherein the first refractive index is at least 0.5 higher than the second refractive index. A graded index layer of a continuously changing graded refractive index is deposited over the Bragg-reflector structure, wherein the graded refractive index changes continuously from a third refractive index to the first refractive index, and wherein a thickness of the graded index layer is selected such that a reflection coefficient for a light of a visible wavelength varies by no more than 25 percent for a visible wavelength range of 400-700 nanometers.

In particular non-limiting embodiments, the system for depositing a non-dichroic coating thin film is provided. The system comprises a control system having a processor for executing instructions that cause, the control system to transmit signals to operate mass flow controllers for the deposition of precursor gases, and for maintaining temperature and pressure control within a reaction chamber, the instructions causing the processor to perform operations which include receiving optical properties of a substrate including the color of the substrate obtained from spectrophotometer measurements, receiving a reflectance requirement for the substrate, and based on the received optical properties and the reflectance requirement, selecting a formula for the deposition of the non-dichroic coating thin film over the substrate, wherein the selecting of the formula comprises determining a set of parameters for the non-dichroic coating thin film. The non-dichroic coating thin film comprises a Bragg-reflector structure deposited over the substrate, the Bragg-reflector structure having a plurality of pairs of layers, each pair having a first layer and a second layer. The first layer comprises a first material of a first refractive index and has a first thickness of a quarter of a target wavelength determined within the first layer, the first layer adjacent to the second layer. The second layer comprises a second material of a second refractive index and has a second thickness of a quarter of the target wavelength determined within the second layer, wherein the first refractive index is at least 0.5 higher than the second refractive index. Further, the non-dichroic coating thin film includes a graded index layer of a continuously changing graded refractive index deposited over the Bragg-reflector structure, wherein the graded refractive index changes continuously from a third refractive index to the first refractive index; and. Further, determining the set of parameters includes determining the target wavelength and determining the thickness of the graded index layer.

The embodiments disclosed herein are only examples, and the scope of this disclosure is not limited to them. Some embodiments may include all, some, or none of the components, elements, features, functions, operations, or steps of the embodiments disclosed herein. The dependencies or references back in the attached claims are chosen for formal reasons only. However, any subject matter resulting from a deliberate reference back to any previous claims (in particular multiple dependencies) can be claimed as well, so that any combination of claims and the features thereof are disclosed and can be claimed regardless of the dependencies chosen in the attached claims. The subject-matter which can be claimed comprises not only the combinations of features as set out in the attached claims but also any other combination of features in the claims, wherein each feature mentioned in the claims can be combined with any other feature or combination of other features in the claims. Furthermore, any of the embodiments and features described or depicted herein can be claimed in a separate claim and/or in any combination with any embodiment or feature described or depicted herein or with any of the features of the attached claims.

## BRIEF DESCRIPTION OF THE DRAWINGS

FIG. 1A is an example schematic view of a non-dichroic coating thin film structure, according to an embodiment.
FIG. 1B is another example schematic view of a non-dichroic coating thin film structure, according to an embodiment.
FIGS. 2A and 2B are example refractive index profiles for a graded index layer, according to an embodiment.
FIG. 3 shows example reflectance graphs for different non-dichroic coating thin film structures, according to an embodiment.
FIG. 4 is an example structure of a graded index layer, according to an embodiment.
FIG. 5 illustrates possible rate and material profiles for deposition of a non-dichroic coating thin film structure, according to an embodiment.
FIG. 6 is an example system for the deposition of a non-dichroic coating thin film structure, according to an embodiment.
FIG. 7 is an example method for the deposition of a non-dichroic coating thin film structure, according to an embodiment.
FIGS. 8A-8E are example approaches for determining parameters used for obtaining a deposition formula for depositing a non-dichroic coating thin film structure, according to an embodiment.
FIG. 9 is an example computer system for controlling the deposition of non-dichroic coating thin film structure, according to an embodiment.

## DETAILED DESCRIPTION

In the following description, for the purposes of explanation, numerous specific details are set forth to provide a thorough understanding of the present disclosure. It will be apparent, however, that embodiments of the present disclosure may be practiced without these specific details. In other instances, well-known structures and devices are shown in schematic form to avoid unnecessarily obscuring the description of the present disclosure.

The text in conjunction with the accompanying drawings aims to articulate the designs and methods at a level of detail consistent with the communication standards among skilled individuals in the relevant arts. This level of detail mirrors the customary communication among those with expertise in the field, effectively expressing the structure and function of the various designs outlined in this disclosure.

Various embodiments may be described in this disclosure to illustrate various aspects. Other embodiments may be utilized and structural, logical, software, and other changes may be made without departing from the scope of the embodiments that are specifically described. Various modifications and alterations are possible and expected. Some features may be described with reference to one or more embodiments or drawing figures, but such features are not limited to usage in the one or more embodiments or figures with reference to which they are described. Thus, the present disclosure is neither a literal description of all embodiments nor a listing of features that must be present in all embodiments.

Headings of sections and the title are provided for convenience but are not intended as limiting the disclosure in any way or as a basis for interpreting the claims.

A description of an embodiment with several components present does not necessarily imply that all such components are required. Optional components may be described to illustrate a variety of possible embodiments and to illustrate one or more aspects of the present disclosure more fully. Similarly, although process steps, method steps, algorithms, or the like may be described in sequential order, such processes, methods, and algorithms may generally be configured to work in different orders, unless specifically stated to the contrary. Any sequence or order of steps described in this disclosure is not a required sequence or order. The steps of the described processes may be performed in any order practical. Further, some steps may be performed simultaneously. The illustration of a process in a drawing does not exclude variations and modifications, does not imply that the process or any of its steps are necessary, and does not imply that the illustrated process is preferred. The steps may be described once per embodiment but need not occur only once. Some steps may be omitted in some embodiments or some occurrences, or some steps may be executed more than once in each embodiment or occurrence. When a single device or article is described, more than one device or article may be used in place of a single device or article. Where more than one device or article is described, a single device or article may be used in place of more than one device or article.

The functionality or features of a device may be alternatively embodied by one or more other devices that are not explicitly described as having such functionality or features. Thus, other embodiments need not include the device itself. Techniques and mechanisms described or referenced herein will sometimes be described in singular form for clarity. However, it should be noted that embodiments include multiple iterations of a technique or multiple manifestations of a mechanism unless noted otherwise.

### *Definitions*

In various embodiments of the disclosure, terms such as "approximate," "about," "similar," "equal," "equivalent" or "the same as" are used to indicate a degree of flexibility or tolerance in numerical values, measurements, and characteristics disclosed. The scope of the disclosure should not be limited to strict numerical precision, and these terms are employed to allow for variations within acceptable limits.

The terms "approximate," "about," and "similar" are used interchangeably to convey that a given value, parameter, or characteristic may deviate within a reasonable range from the stated value. This range may encompass slight variations that do not materially affect the functionality or performance of the systems and methods described in this disclosure. For example, the terms "approximate," "about," and "similar" may refer to a variation of ten percent from a specific value.

The terms "equal," "equivalent," or "the same as" are used to indicate that values, parameters, or characteristics described as such are substantially identical or sufficiently close in magnitude, without necessarily requiring absolute precision. For example, such terms may be referred to a deviation of a few percent from a specific value such as one or two percent.

Further, the term "similar" may be employed to denote a likeness or resemblance between two or more elements, aspects, or features, allowing for variations that do not compromise the fundamental nature or purpose of the disclosure.

In various embodiments of the disclosure, the term "set" is employed to denote a grouping or collection of objects, elements, components, or entities. The flexibility in the interpretation of the term "set" allows for adaptability and practical application in situations where a singular object satisfies the intended functionality or purpose of the disclosure. Thus, the disclosure is not limited to instances where a "set" must consist of multiple objects but rather contemplates scenarios where a "set" may include one object.

*Non-Dichroic Thin Film Structure*

The design of thin film anti-reflection (AR) coatings and Bragg reflectors traditionally involves one or more layers of thin films, each consisting of materials with low and high refractive indices. A limitation of this multilayer approach is that it only provides specific antireflection or reflection properties within a certain range of wavelengths and viewing angles. At angles greater than normal incidence to such thin films or beyond the designed angle of incidence (AOI), there is a phenomenon known as dichroism, which is an optical phenomenon where a material exhibits two different colors or absorbs light differently when viewed from different angles or under different polarizations of light. The number of layers in the multilayer thin film stack in some cases, can exceed 100 layers, increasing the complexity of the coating process.

This disclosure describes a process for depositing a continuous layer with a gradually increasing refractive index (typically above 2.0) using various techniques like physical vapor deposition (PVD) methods (thermal evaporation, sputtering, etc.), chemical vapor deposition (CVD), or plasma-enhanced chemical vapor deposition (PECVD). The deposited material undergoes a chemical reaction with a reactive gas (such as nitrogen or oxygen) in CVD processes, or interacts with the gas in PVD methods, in a gradually increasing ratio, starting from 0 and reaching slightly below the balanced stoichiometric value or about the same as stoichiometric value. For example, a layer of deposited material may be a silicon mononitride described by formula $Si_1N_1$, non-stoichiometric silicon nitride ($Si_aN_b$), or stoichiometric silicon nitride $Si_3N_4$. In a non-stoichiometric form $Si_aN_b$, values for "a" can range between 1 and 3, and for "b" can range between 1 and 4.

During a deposition process, a mass flow controller typically is configured to regulate the gas flow. In some cases, the mass flow controller may be regulated via a suitable control system having a processor configured to execute instructions for controlling the flow of gases. Additionally, or alternatively, manual adjustments to the flow of gases are also possible during deposition. By regulating a mass flow of precursor gases, a film with a changing composition can be formed. Such film can have a gradual variation in the refractive index, forming a graded index layer. As an example, a deposited thin film can have a continuously changing refractive index and absorption coefficient throughout its thickness, acting as a "neutral density" filter. This filter appears uniformly darker without any color shift (dichroism) regardless of the viewing angle.

One feature of the deposition process for creating optical films with a graded index is the ability to achieve any desired shade of "neutral density." This is accomplished by halting the deposition at any point before the element or compound reaches its balanced stoichiometric ratio. Additionally, this process is fully compatible with web or roll-to-roll thin film coating methods, which are commonly utilized for coating various surfaces, including those of aircraft.

The present disclosure describes a non-dichroic coating thin film structure deposited over a substrate. The substrate can be composed of any suitable material, including metal, ceramic, plastic, fabric, or similar materials. The substrate may have substrate-related optical properties which include the color of a substrate, the reflectivity of the substrate, light scattering, and the like. Such substrate-related optical properties may determine properties or parameters of the non-dichroic coating thin film structure to be deposited on such substrate, as further described below.

The non-dichroic coating thin film structure may include a Bragg-reflector structure deposited over the substrate and having a plurality of pairs of layers, each pair having a first layer and a second layer. The first layer may be formed from a first material having a first refractive index $n_1$. The first layer may have a first thickness $d_1$, which may be a quarter of a target wavelength determined within that first layer. For example, if a target wavelength of light in a vacuum is $\lambda_0$, then the wavelength of light in the first layer with the first refractive index $n_1$ is given by $\lambda_0/n_1$. Thus, the first layer may have a thickness of $d_1 = \frac{1}{4} \lambda_0/n_1$.

The first layer is followed by the second layer. The second layer is formed from a second material of a second refractive index $n_2$ and has a second thickness $d_2$ of a quarter of the target wavelength determined within the second layer. For example, the second thickness $d_2 = \frac{1}{4} \lambda_0/n_2$. In an example embodiment, the first refractive index is at least 0.5 higher than the second refractive index (e.g., $n_1 - n_2 \geq 0.5$).

In addition to the Bragg-reflector structure, the non-dichroic coating thin film structure features a graded index layer with a continuously changing refractive index, deposited over the Bragg-reflector. This graded refractive index is designed to transition smoothly from a third refractive index to a first refractive index. In various instances, the parameters of the graded refractive index layer can be adjusted to enhance overall transparency and to produce reflective properties that are not significantly dependent on the angle of incidence of the illuminating light. Such parameters could include, for example, the thickness of the graded index layer. Specifically, the thickness of this layer may be optimized so that the reflection coefficient for visible light wavelengths varies by no more than 25 percent within the range of 400 to 700 nanometers (nm). Depending on the material used for the graded index layer, its thickness may range from 0.1 to about 1 micron. In some scenarios, for materials with high transparency to visible light, the graded index layer may be a few microns thick.

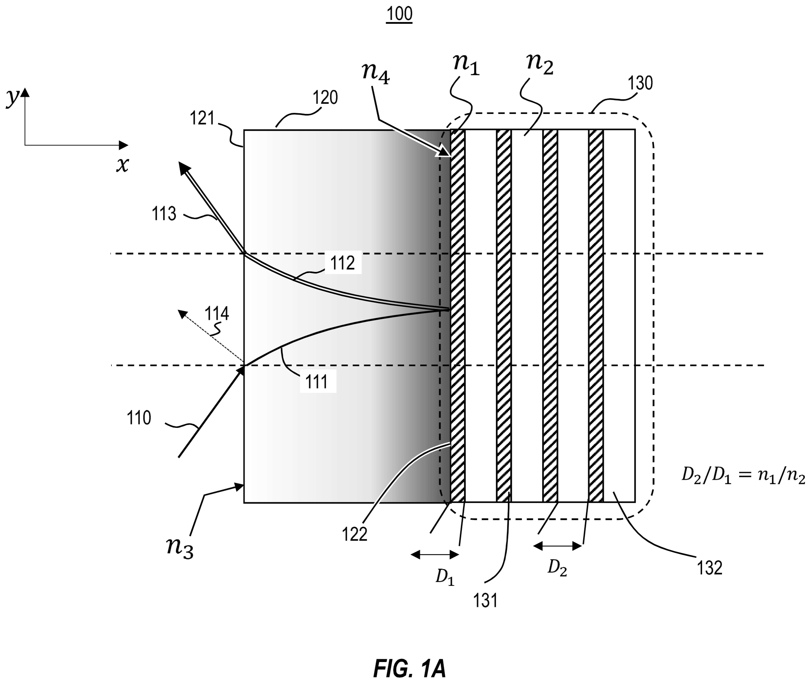

FIG. 1A illustrates a non-dichroic coating thin film structure 100, which includes a graded index layer 120 and a Bragg-reflector structure 130. The non-dichroic coating thin film structure 100 extends in x and y directions as shown in FIG. 1A. As depicted, a light ray 110 strikes surface 121 of the graded index layer 120, subsequently following a path 111 influenced by the graded index of refraction of layer 120. Additionally, as indicated by reflected ray 114, some of the light is reflected at surface 121. The extent of reflection at this surface is determined by the Fresnel equations and depends on the angle of incidence of ray 110 and the refractive index $n_3$ of graded index layer 120 near surface 121. Therefore, selecting a material for surface 121 allows for the choice of refractive index $n_3$, which can be leveraged to control the reflective properties of non-dichroic coating thin film structure 100. In an example embodiment, refractive index $n_3$ may be selected to be in a range between 1.5 and 2.5.

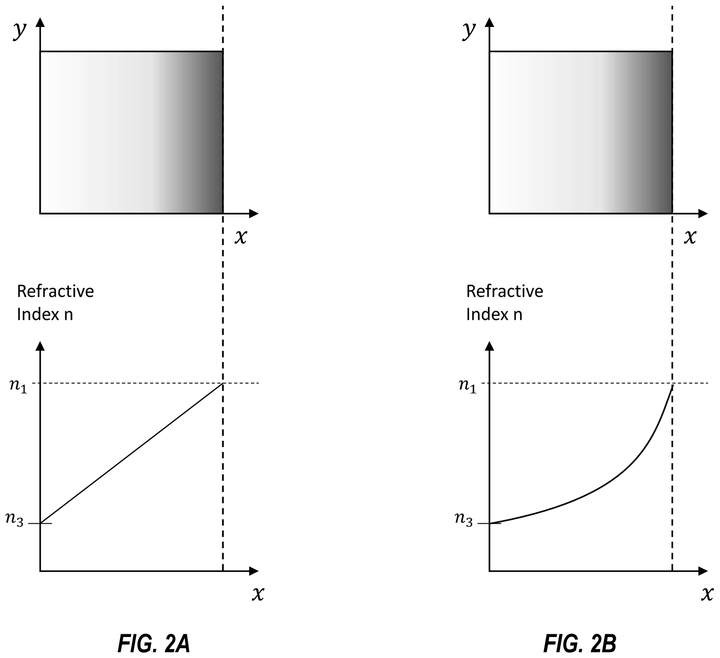

FIG. 1A shows that graded index layer 120 has a refractive index $n_3$ at surface 121 and a refractive index $n_4$ at a surface 122, which is a surface at an interface between graded index layer 120 and Bragg-reflector structure 130. Refractive index $n_4$ is configured to be larger than refractive index $n_3$. Further, graded index layer 120 is formed from a material with a continuously changing refractive index $n_g(x)$. Refractive index $n_g(x)$ is configured to continuously increase along a direction $x$ from the value of $n_3$ to the value of $n_4$. In some cases, refractive index $n_g(x)$ can vary linearly as shown in FIG. 2A. Alternatively, refractive index $n_g(x)$ can vary in any suitable way. For example, FIG. 2B shows that refractive index $n_g(x)$ varies parabolically. In many instances, the values for refractive indices $n_1$, $n_2$, $n_3$, and $n_4$ are specified for visible wavelengths. These wavelengths fall within a range of 400 to 800 nm.

In some cases, graded index layer 120 may be formed from a binary compound such as silicon nitride (SiN) which may be represented by a stoichiometric formula of $Si_3N_4$. In various embodiments, graded index layer 120 may be selected from a composite material comprising variable molar fractions of silicon and nitrogen. Note that any suitable ratios of silicon-to-nitrogen can be used such that index of material changes from substantially a value of about 1.5 or 2 near surface 121 to a value that can be in a range of about 3.5 to 2.5 near surface 122. For example, for silicon-rich layer the index of refraction can be substantially high and reach values of about 3.5 and for nitrogen-rich layer the index of refraction can be about 2 or less. It should be noted that other materials can be used besides silicon or nitrogen. For instance, such materials may include TiO2, GaN, AlGaN, AlN, SiO2, MgO, Al2O3, ZnS, ZnO, Ga2O3, BN, InN, InGaN, GaP, Diamond, and combination thereof.

In various embodiments, the composite material such as SiN can be deposited using any suitable approaches such as PVD, CVD, PECVD, sputtering, and the like. For example, graded index layer 120 comprising a silicon nitride layer may be deposited using a chemical vapor deposition, and the variable molar fractions of silicon and nitrogen may be determined by a mass flow rate of silane and ammonia gases. In some cases, not only the graded index layer but the entire non-dichroic coating thin film structure 100 can be deposited using PVD, CVD, PECVD, sputtering, and the like. In some cases, a portion of a structure, such as, for example, a Bragg-reflector structure may be deposited using a first approach, such as PVD, and a second portion of the structure may be deposited using a different approach, such as CVD. In an example embodiment, when using CVD, the process may be plasma enhanced (e.g., using PECVD) to reduce a substrate temperature to suitable temperature values (e.g., to a few hundred degrees Celsius). It should be noted that a particular deposition process may be selected based on the type of substrate being used. For example, a CVD may be selected when the substrate is capable of withstanding high temperatures, and a PVD may be selected when the substrate cannot be heated to high temperatures of several hundred degrees Celsius.

In various embodiments, the Bragg-reflector structure 130 is designed to reflect light that impinges on surface 122 from a range of angles. Optimal reflection occurs when there is a relatively small angular deviation from a normal direction to surface 122. It should be noted that the graded index layer 120 is engineered to bend the light path, as illustrated by path 111. Consequently, the light ray traveling along this path exhibits less angular deviation from the normal compared to light ray 110 at surface 121.

As shown in FIG. 1A, Bragg-reflector structure 130 includes a plurality of pairs of layers such as first layers 131 followed by second layers 132. First layer 131 is configured to be adjacent to graded index layer 120. In an example embodiment, an index of refraction of first layer 131 may be $n_1$, the same as the index of refraction $n_4$ of graded index layer 120 near surface 122. Alternatively, in some cases, $n_1$ may be different from $n_4$. For example, an absolute difference $|n_1-n_4|$ may be as much as 0.5 or more. In some cases, n1 may be greater than n4, and in other cases, n1 may be less than n4.

In various embodiments, second layer 132 follows first layer 131. First layer 131 and second layer 132 form a pair that can be repeated multiple times. For instance, Bragg-reflector structure 130 may include a few pairs of layers 131 and 132, a few tens of pairs of layers 131 and 132, or even about a hundred pairs of layers 131 and 132. As shown in FIG. 1A, the thickness of first layer 131 is denoted by $D_1$, the thickness of second layer is denoted by $D_2$, and thicknesses $D_1$ and $D_2$ are selected such that a ratio of $D_2/D_1$ is equal to $n_1/n_2$. In an example embodiment, $D_1$ may be selected such that $D_1 = \lambda_0/n_1$.

In various embodiments, material for first layer 131 may be selected such that $n_1$ is higher than $n_2$. The larger the difference between $n_1$ and $n_2$, the more effective is Bragg-reflector structure 130. In some cases, $n_1$ may be in a range of about 2.5 to about 3.5 and $n_2$ may be in a range of about 1.5 and 2.5.

FIG. 1A shows that a ray along path 111 is reflected from Bragg-reflector structure 130, and subsequently follows path 112, which, similar to path 111, is not straight due to the graded refractive index of graded index layer 120. The ray is configured to exit graded index layer 120 as reflected ray 113.

In various embodiments, Bragg-reflector structure 130 may be deposited over a substrate. In an example embodiment, second layer 132 is deposited over the substrate following first layer 131. In some cases, prior to depositing second layer 132, a buffer layer may be deposited over the substrate. The buffer layer may be used to present a layer with low roughness, or a layer to which the second layer 132 can be well adhered.

In various embodiments, the thicknesses of first and second layer 131 and 132 may be influenced by a peak wavelength at which a reflection from Bragg-reflector structure 130 is desired. For example, when the substrate is colored red, to prevent the reflected light from having a pronounced red wavelength (e.g., wavelength in a range of about 650-800 nm) a complementary color to red (e.g., green wavelength in a range of about 490-570 nm) can be reflected by Bragg-reflector structure 130 while transmitting at least some light in the red wavelength. That is, the Bragg-reflector structure 130 may be designed such that it effectively reflects the green light.

Bragg-reflector structure 130 can utilize tens or hundreds of layers. In some cases, the thickness of Bragg-reflector structure 130 is about a tenth of a micron, a half of a micron, a micron, or one and a half micron.

Furthermore, the thickness and composition of graded index layer 120, may be determined based on a reflectivity requirement of non-dichroic coating thin film structure 100. For more reflective films, the thickness of graded index layer 120 may be less than a micron (e.g., about 0.1-1 micron including all the values in between), and for less reflective films, graded index layer 120 may be thicker than a micron (e.g., 1-3 microns). The reflectivity of non-dichroic coating thin film structure 100 may be selected to have any suitable value based on the requirement for the application of such film. For instance, in some cases, the reflectivity of non-dichroic coating thin film structure 100 may be more than 10 percent. In some cases, the composition of graded index layer 120 may be selected such that the film is about fifty percent reflective at a thickness of about 0.1 microns.

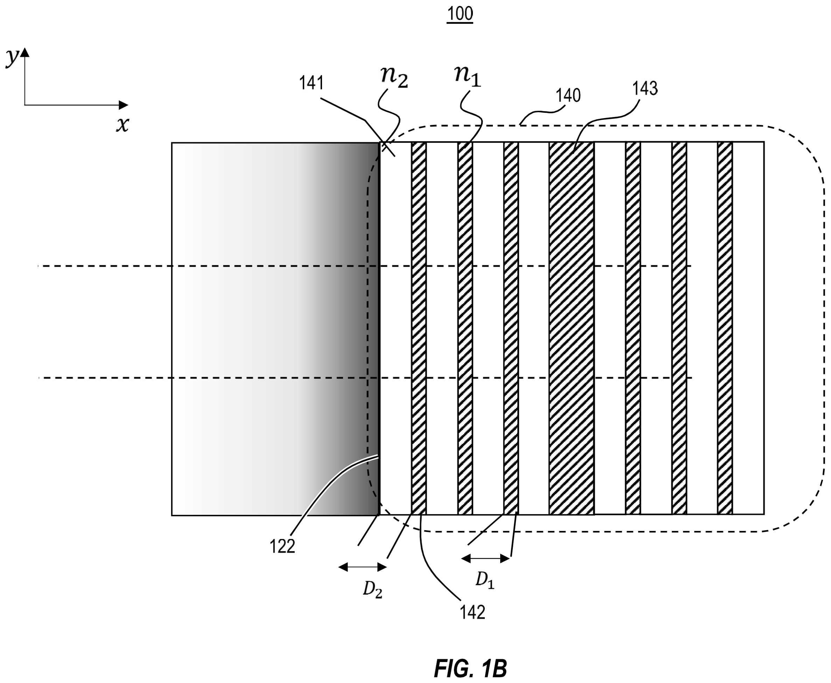

It should be noted, that in some cases, instead of having a Bragg-reflector structure 130, a Fabry-Perot structure can be used. An example of Fabry-Perot structure 140 is shown in FIG. 1B. Such structure may be similar to Bragg-reflector structure 130 but may allow a peak wavelength to pass through while generally reflecting other wavelengths. Fabry-Perot structure 140 is characterized by a plurality of pairs of layers, each pair formed from a second layer 142 and a first layer 141 which may be respectively similar in structure and material to second layer 132 and first layer 131. Note that second layer 142 of Fabry-Perot structure 140 is configured to be adjacent to surface 122 of graded index layer 120. Second layer 142 is a layer of the refractive index of $n_2$ and is followed by first layer 141 of the refractive index of $n_1$.

Further, Fabry-Perot structure 140 includes a third layer 143 of the index of refraction $n_1$ sandwiched in the middle of the plurality of pairs of layers 142 and 141. In an example embodiment, Fabry-Perot structure 140 may be configured based on a particular peak wavelength of light that may be transmitted. For instance, if a light of wavelength $\lambda_0$ (as measured in vacuum) needs to be transmitted, then second layer 142 may have a layer thickness of $D_2 = 1/4\ \lambda_0/n_2$, and first layer 141 may have a layer thickness of $D_1\ 1/4\ \lambda_0/n_1$. For Fabry-Perot structure 140, third layer 143 has a thickness that is twice the thickness of the first layer: $D3 = =1/2\ \lambda_0/n_1$. In an example embodiment, when a substrate is of a particular color, such as red color, Fabry-Perot structure 140 may be configured to transmit through only light of wavelengths corresponding to that color, while reflecting most of the other colors.

In various cases, as described above, the thicknesses of first and second layers 131 and 132 for Bragg-reflector structure 130, and first and second layers 141 and 142 for Fabry-Perot structure 140, as well as third layer 143 for Fabry-Perot structure 140 are determined based on a target wavelength that needs to be reflected (in case of Bragg-reflector structure 130) or transmitted (in case of Fabry-Perot structure 140). In some cases, the target wavelength may be determined based on the color of the substrate. For example, in the case of Bragg-reflector structure 130, the target wavelength may correspond to a color that is complementary to the color of the substrate, and in the case of Fabry-Perot structure 140, the target wavelength may correspond to the color of the substrate (e.g., if the color of the substrate is red, the wavelength may be about 650 or 800 nm).

It should be noted, that while Bragg-reflector structure 130 is shown in FIG. 1A and Fabry-Perot structure 140 is shown in FIG. 1B, other structures can be combined with graded index layer 120 to form a non-dichroic coating thin film structure. For example, in some cases, the non-dichroic coating thin film structure can include a first Bragg-reflector structure and a second Bragg-reflector structure deposited between the substrate and the first Bragg-reflector structure. In some embodiments, the first Bragg-reflector structure may be similar or identical to Bragg-reflector structure 130 while the second Bragg-reflector structure may be configured to reflect light at a second target wavelength that is different than the target wavelength of the first Bragg-reflector structure (herein, for clarity referred to as the first target wavelength). For example, the second target wavelength may be different from the first target wavelength by at least a hundred nanometers, and in some cases, the difference between the first and the second target wavelength may be a few hundred nanometers.

It should be noted that not only two Bragg-reflector structures may be combined but also other combinations can be possible, such as several Fabry-Perot structures can be combined, or Bragg-reflector structures can be combined with Fabry-Perot structures.

It should be noted, that in some embodiments, graded index layer such as graded index layer 120 may be deposited directly over a substrate without the presence of a Bragg-reflector structure, such as Bragg-reflector structure 130 or the presence of a Fabry-Perot structure 140. In an example embodiment, such a graded index layer may be less than a micron thick and may have a composition that allows for about 10-30 percent reflectance. In some cases when the graded index layer is about half of a micron thick the reflectance may be about fifty percent.

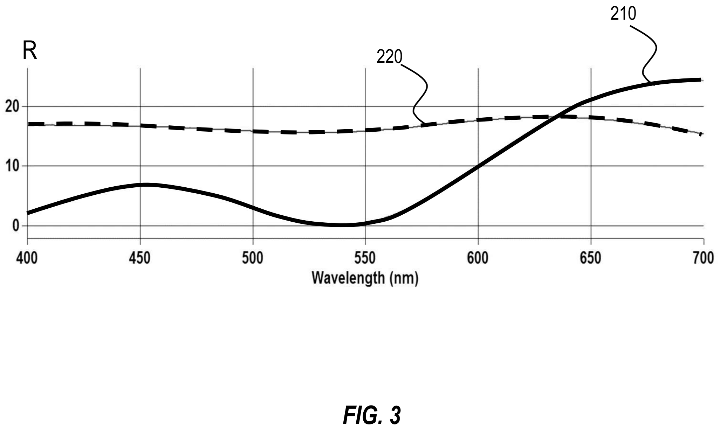

FIG. 3 shows an example of reflectance from a substrate with and without the presence of a graded index structure. In FIG. 3, graph 210 shows a reflectance coefficient R as a function of a wavelength when a Bragg-reflector structure having 14 layers is deposited over the substrate. The Bragg-reflector structure has a thickness of about 1.5 microns. As shown, the reflectance coefficient R varies by about 20% or more when such film is deposited over a substrate. Graph 220, illustrated in FIG. 3, shows the reflectance coefficient R as a function of a wavelength when a graded index layer of about 0.7 microns thick is deposited over a substrate. As shown by graph 220, the variation in reflectance coefficient R as a function of a wavelength is significantly less than for graph 210. For example, the variation in reflectance coefficient R for graph 220 is less than 10 percent over a wavelength range of 400 to 700 nm.

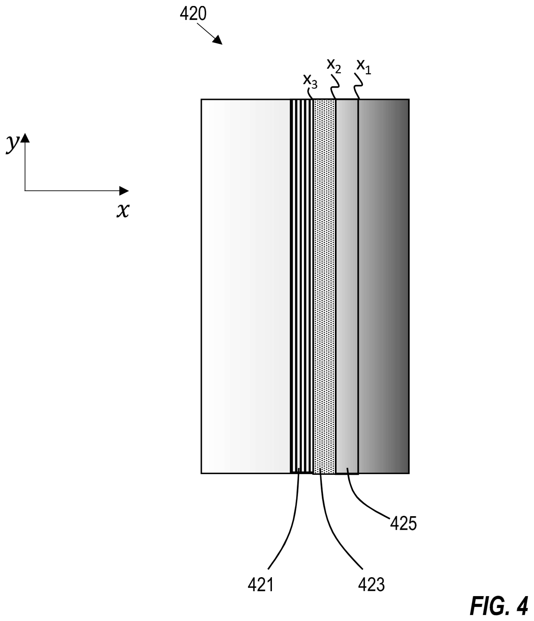

FIG. 4 illustrates a graded index layer 420, which may include sublayers 421, 423, and 425. These sublayers can further control the optical and/or mechanical properties of graded index layer 420. For instance, some of the sublayers can be used to reduce mechanical stresses within graded index layer 420, thereby decreasing the number of defects and/or cracks in this layer. Additionally, some sublayers may be engineered to control light scattering. For example, sublayer 423 may be developed under conditions that exhibit a lateral variation in the index of refraction, resulting in light scattering. This sublayer could be formed by initially creating islands of a first material with a specific index of refraction and subsequently depositing a second material with a different index of refraction. These islands might be formed during the deposition process. For instance, during the deposition, sublayer 425 at locations $x_1$ to $x_2$, made from a binary compound, may be deposited with an index of refraction ranging from $n_g(x_1)$ to $n_g(x_2)$. Adjacent to sublayer 425, sublayer 423 may be deposited with an index of refraction ranging from $n_g(x_2)$ to $n_g(x_3)$, but with morphological properties that induce scattering. These properties may include islands of the first material surrounded by the second material. For example, sublayer 423 might be deposited using CVD, PECVD, or PVD at certain temperature and pressure conditions that promote island formation with a specific combination of precursor gases or materials, followed by deposition at different temperature and pressure conditions using another combination of precursor gases or materials to fill the gaps between the islands. In one example, the first material may be a SiN composition rich in nitrogen, while the second material may be a SiN composition rich in silicon. Alternatively, the first material may be silicon-rich SiN, and the second, nitrogen-rich SiN. In a specific implementation, sublayer 423 may include lateral inhomogeneities in the index of refraction on a length scale of 50 nm, 100 nm, 200 nm, 300 nm, 400 nm, 500 nm, 600 nm, 700 nm, and similar, with a fluctuation in the index of refraction of about 10% or more. In some cases, these fluctuations may be on the order of a micron or more. The islands within sublayer 423 may be spaced at a characteristic distance of 50-1000 nm and formed from a material whose index of refraction is at least 10% different than the surrounding material. The characteristic distance may be measured as the diameter of an island at its widest point, or the square root of an island's area. Sometimes, the characteristic distance between islands may be similar to the characteristic size of the islands. In various cases, these characteristic distances are statistical quantities determined by averaging the diameters (or square root of areas) of various islands. Similarly, the characteristic distance between islands is a statistical quantity determined by averaging the distances between islands.

In some cases, specific sublayers may be deposited to reduce lateral inhomogeneity within the sublayers. By achieving greater uniformity, these sublayers enhance the overall durability of the graded index layer 420 and improve stress management. This reduction in inhomogeneity helps prevent the initiation and propagation of cracks by creating stress fields that counteract crack formation and growth. Additionally, such sublayers can be optimized to control diffusive optical scattering, ensuring better optical performance by maintaining clarity and reducing unintended light dispersion.

FIG. 4 illustrates that another layer, 421, can also be deposited. This layer may consist of a superlattice composed of materials with varying compositions. For example, sublayer 421 could include alternating thin layers of a first material with a specific index of refraction followed by thin layers of a second material with a different index of refraction. These layers can be formed to be a few tens of nanometers thick and may help further adjust the index of refraction of a graded layer and/or introduce scattering. In one implementation, the difference in the refractive index between the first and second materials may be at least 10% or more.

It should be noted that various changes in the growth condition of layers can result in specific optical properties of the deposited layers such as refractive index of these layers, light scattering characteristics, and the like. Further, different deposition approaches can affect the mechanical or optical properties of such layers. In some cases, for better mechanical/optical performance, at least some of the regions of a graded index layer may be annealed by increasing the temperature during the deposition process. In some cases, changes of pressure can be made.

Temperature can play an important role in the thin film deposition process, particularly in how it influences the mobility of atoms on the surface. When the temperature is elevated, the surface mobility of deposited atoms can increase, allowing them to diffuse more easily across the substrate. This enhanced mobility helps to create a more densely packed sublayers (also herein referred to as films) with fewer voids and defects. In essence, a certain range of deposition temperatures can result in a thin film with better structural uniformity, higher density, and potentially improved optical and mechanical properties.

In many cases, however, thin film deposition may be constrained to lower temperatures (e.g., temperatures on an order of room temperature) especially those involving polymer substrates. Polymer substrates typically have low thermal tolerance and exposing them to elevated temperatures could lead to deformation or other forms of degradation. As a result, room temperature processes are often used, though this limits the ability to take full advantage of the temperature's effects on surface mobility and film density.

Pressure during the deposition process offers another means of controlling the characteristics of a thin film. By adjusting the deposition pressure, intrinsic stresses within the film can be effectively managed. Different pressure regimes can lead to variations in stress characteristics. For instance, at some pressures, films with reduced internal stress may be deposited, while at other pressures films with compressive or tensile stresses may be deposited, depending on the specific material and deposition technique. Managing these stresses is important for ensuring the mechanical stability of the film, particularly in applications where the film may be exposed to thermal cycling or mechanical loads over time. In certain cases, selecting an appropriate pressure regime can facilitate the scattering of incoming atoms (adatoms), improving their distribution across the surface of the substrate and leading to more uniform film deposition.

In various elements or compounds, there can be a specific pressure at which a "neutral" stress (neither tensile nor compressive) is achieved for a given film thickness. However, as the film's thickness increases, this neutral pressure shifts due to changes in the film's structure. Typically, tensile stress occurs at lower pressures (<3 millitorr), which can cause peeling, while compressive stress arises at higher pressures (>10 millitorr), leading to blisters or buckling. To achieve the desired effects, such as increased voids or altered stress levels, it's important to determine the pressure values during a deposition process and how much adjustment is necessary. For example, for the graded index in the visible spectrum range of 400-700 nm, a thickness of 3,500 Å is generally sufficient to produce the required optical effects. At this thickness, a stable deposition pressure between 2-4 millitorr can be maintained without significant stress-related issues.

Additionally, reducing the pressure during deposition (e.g., to below approximately 3 millitorr) can increase the density of the deposited film by shortening the mean free path for adatoms at lower temperatures. Conversely, higher pressures (above approximately 5 millitorr) result in a less dense film. In some cases, alternating the pressure between these two ranges (below approximately 3 millitorr and above 5 millitorr) can induce density fluctuations in the film, effectively modulating internal stresses. These pressure variations can be applied to sublayers with thicknesses ranging from a few tens of angstroms (e.g., 10-90 Å) to a few hundreds of angstroms (e.g., 100-900 Å), including all values within these ranges. Furthermore, if it is determined that the film exhibits tensile stress exceeding a certain threshold (e.g., based on deposition parameters), the pressure can be adjusted to shift deposition toward compressive stress conditions, thereby balancing the overall stress in the film.

Pressure also has a significant impact on the optical properties of the thin film, particularly its refractive index. By adjusting the deposition pressure or selecting a specific pressure regime, microscopic voids or occlusions can be introduced into the film. These occlusions lower the refractive index, which may be beneficial in applications requiring lower refractive indices for improved optical performance. However, in some cases, these voids can reduce the film's adhesion to the substrate and lower its overall density, resulting in a more fragile and less durable film. Therefore, while pressure adjustment is a valuable tool for tuning optical properties, it requires a delicate balance to avoid compromising the mechanical integrity of the thin film.

In one implementation, a cost function can be introduced to represent this balance between optical performance and mechanical integrity. A possible cost function might be a weighted sum of scores, where one score corresponds to the optical properties of the film (e.g., desired refractive index, transparency, or light scattering characteristics), and another score corresponds to the mechanical integrity of the film (e.g., adhesion, density, and stress tolerance). The cost function can be dependent on the pressure parameter, and the goal could be to optimize this function to achieve the best trade-off between optical and mechanical properties. For example, if $C(p)$ is the cost function, where p is the deposition pressure, it could take the form: $C(p) = w_1 \cdot f_{optical}(p) + w_2 \cdot f_{mechanical}(p)$, where $f_{optical}(p)$ represents the score for optical properties, $f_{mechanical}(p)$ represents the score for mechanical properties, and $w_1$ and $w_2$ are weighting factors that reflect the importance of each property for the given application. The function $C(p)$ can then be optimized with respect to pressure p to find the pressure regime that delivers the optimal balance between these competing factors.

Examples of $f_{optical}(p)$ and $f_{mechanical}(p)$ can include any suitable functions. For example, To implement a cost function that accounts for deviations from a target graded refractive index, one can define the optical part of the cost function $f_{optical}(p)$ as a function evaluating the amount of the actual refractive index profile $n(z, p)$ deviates from the target graded profile $n_T(z)$.

Such function can be for example, $f_{optical}(p) = \int_0^d \left[ \left( \frac{n(z,p)}{n_{T(z)}} - 1 \right) \right]^2 dz$, with d being a total thickness of the graded index layer. This integral captures how much the actual refractive index deviates from the target at each point in the film. The goal would be to minimize this function to ensure that the actual refractive index closely follows the desired graded profile. It should be noted that illustrated function is just one possible example, and any other suitable functions may be defined.

Similarly, $f_{mechanical}(p)$ can be any suitable function. Such function could measure the mechanical integrity of the film by accounting for factors such as film adhesion, density, and internal stress. One way to define this is by using a model that penalizes some outlying mechanical properties such as, for example, high internal stresses, low density, and poor adhesion. For example, if the stress in the film is $\sigma(p)$, the film density is $\rho(p)$, and the adhesion strength is $A(p)$, the function could look like: $f_{mechanical}(p) = \beta_1 \cdot \sigma(p)^2 - \beta_2 \cdot \rho(p) + \beta_3 \cdot 1/A(p)$. Such function can be used to minimize stress $\sigma(p)$, density $\rho(p)$, and maximize adhesion strength is $A(p)$. Here $\beta_1$, $\beta_2$, and $\beta_3$, are weights that balance the importance of stress, density, and adhesion. It should be noted that $f_{mechanical}(p)$ is only one possible example of a function and any other suitable functions can be used.

## Deposition system and method for graded index layer

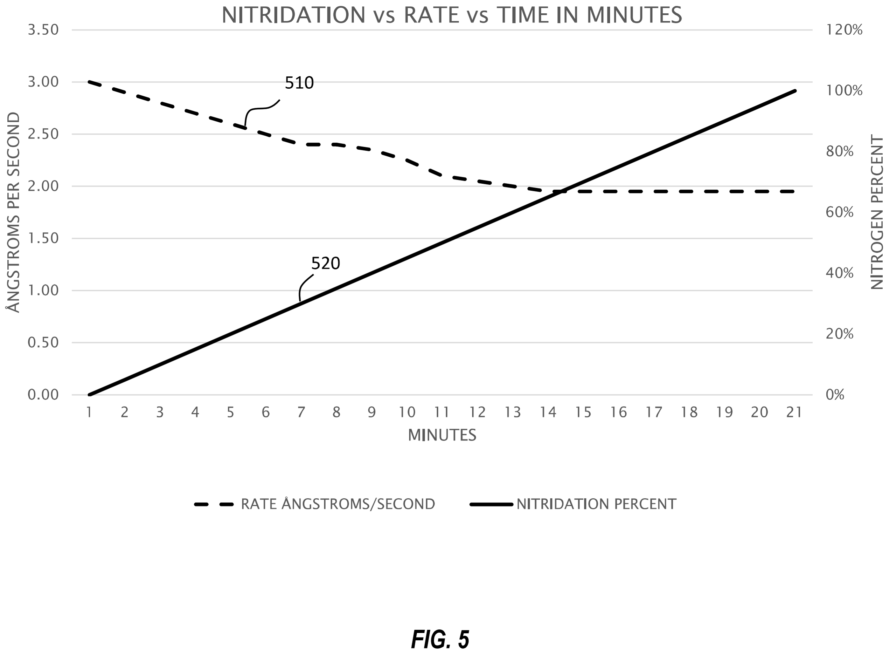

FIG. 5 depicts graphs 510 and 520 illustrating the material composition and deposition rate as a function of time and film thickness, during the deposition process of a graded index layer, such as graded index layer 120. As shown in FIG. 5, the material composition represented by graph 520 may vary mostly linearly as a function of time when depositing the graded index layer. For instance, graph 520 displays the percentage of nitrogen deposited as it replaces oxygen in the composition of a silicon oxynitride $Si_xO_yN_z$. For example, when there is no nitrogen (z=0), the composition of the material is $SiO_2$, and when there is 100 percent of nitrogen (z=4) the composition of the material is $Si_3N_4$. In general, the relationship between x, y, and z is determined by the valency (bonding capacity) of the atoms involved, particularly silicon, oxygen, and nitrogen. Silicon typically forms four bonds in compounds, oxygen forms two bonds, and nitrogen generally forms three bonds. The stoichiometry must balance these bonding requirements, generally requiring for a stable compound that 4x=2y+3z. Which can yield silicon oxynitrides such as $SiO_2$ (x=1, y=2, z=0), $Si_3N_4$ (x=3, y=0, z=4), $Si_2O_1N_2$, (x=2, y=1, z=2), $Si_3O_3N_2$ (x=3, y=3, z=2), and the like. As shown in FIG. 5, during initial deposition, no nitrogen of a low amount of nitrogen is deposited. However, at the end of the deposition mostly nitrogen is deposited. In an example embodiment, the linear form of graph 520 implies a linearly graded index layer.

Further, the deposition rate is shown by graph 510. In an example embodiment, the deposition rate can be relatively linear for a first period of time (e.g., for a period of about 14 minutes) and subsequently, the deposition rate can become mostly constant of about few angstroms per second. In some cases, when deposition goes beyond stoichiometric ratios, excess of one element (such as silicon) can lead to non-stoichiometric materials, which can introduce unwanted optical effects like dichroism, which leads to the graded layer exhibiting different colors or absorbing light differently when viewed from different angles or under different polarizations of light. This effect occurs when the material's refractive index becomes anisotropic (directionally dependent), leading to variable optical performance depending on the viewing angle.

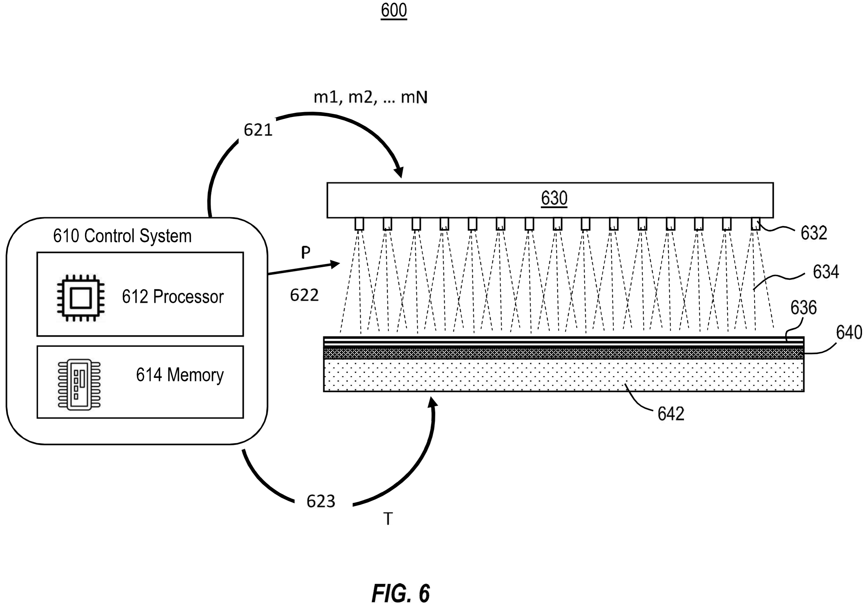

FIG. 6 illustrates system 600, designed for depositing a non-dichroic coating thin film, such as the non-dichroic coating thin film structure 100 shown in FIG. 1A. System 600 may also be used for the deposition of graded index layers, Bragg-reflector structures, and/or Fabry-Perot structures. It includes a control system 610 equipped with a processor 612 that executes instructions stored in memory 614. These instructions enable control system 610 to send signals that manage the mass flow controllers for depositing precursor gases, as well as maintaining temperature and pressure within the reaction chamber. FIG. 6 features a reaction chamber 630 with gas injection nozzles 632 that release precursor gases 634. These gases interact physically and/or chemically above a substrate 640 to form the non-dichroic coating thin film 636. In various embodiments, control system 610, through processor 612, conducts operations that include data collection and deposition steps. As part of the data collection, control system 610 may be configured to receive optical properties of substrate 640, including its color determined from spectrophotometer measurements. This information regarding the substrate's color may suggest the specific structure to be deposited on the substrate. Additionally, as part of data collection, control system 610 may obtain a reflectance requirement for the substrate from a user of system 600. For example, this reflectance requirement might stipulate that the substrate reflects between 10-30 percent of light at visible wavelengths and that variations in the reflectance coefficient with respect to a reflected wavelength in the visible spectrum remain below a specified threshold. Specifically, the variation in the reflectance coefficient could be less than 20 percent over a wavelength range of 400-700 nm, or even less than 10 percent. In some instances, the reflectance requirement may be presented in a table format, as shown in Table 1 below:

Table 1, reflectance requirement table for a non-dichroic coating thin film

| Reflectance (R) | Variation of Reflectance ($\Delta R$) | Wavelength Range |
| --- | --- | --- |
| 10-20% | Less than 5% | 400-500 nm |
| 15-20% | Less than 5% | 500-600 nm |
| 10-20% | Less than 5% | 600-800 nm |

Subsequently, based on the received optical properties and reflectance requirements, control system 610 is configured to select a formula for the deposition of the non-dichroic coating thin film over the substrate. This selection process involves determining a set of parameters for the non-dichroic coating thin film. In one example implementation, the non-dichroic coating thin film includes a Bragg-reflector structure deposited on the substrate, similar or identical to the Bragg-reflector structure 130 shown in FIG. 1A. This Bragg-reflector structure comprises multiple pairs of layers; each pair includes a first layer and a second layer. The first layer is made from a material with a first refractive index and has a thickness of one-quarter of a target wavelength determined within that layer. It is followed by the second layer, which is made from a second material with a second refractive index and has a thickness also equating to one-quarter of the target wavelength determined within the second layer, where the first refractive index is at least 0.5 higher than the second refractive index. Additionally, the non-dichroic coating thin film includes a graded index layer with a continuously changing graded refractive index, similar or identical to graded index layer 120. This graded index layer may be deposited over the Bragg-reflector structure, with the graded refractive index continuously transitioning from a third refractive index to the first refractive index, as exemplified in FIG. 1A. In various instances, determining the set of parameters for the non-dichroic coating thin film involves identifying the target wavelength at which the Bragg-reflector structure will reflect the most light and determining at least the thickness of the graded index layer.

It should be noted, that in some embodiments, Bragg-reflector structure may not be deposited, and the graded index layer may be deposited directly on a substrate. In such cases, determining the set of parameters for the non-dichroic coating thin film involves determining the thickness and optical characteristics such as graded index of refraction $n_g(x)$ for the graded index layer.

Further, when Bragg-reflector structure is present, determining the set of parameters includes determining a type of a first material and a type of a second material that can be used for forming the Bragg-reflector structure. For example, the first and the second material may be SiN with various molar fractions of silicon and nitrogen. For instance, the first material may have a first molar fraction of silicon and the second material may have a second molar fraction of silicon. For instance, the first material may be of the form $Si_{a1}N_{b1}$ while the second material may be of the form $Si_{a2}N_{b2}$, where a1 ≠ a2, and b1 ≠ b2. Additionally, or alternatively, other materials can be used for forming the first and the second material. For example, any suitable materials such as TiO2, GaN, AlGaN, AlN, SiO2, MgO, Al2O3, ZnS, ZnO, Ga2O3, BN, InN, InGaN, GaP, Diamond, and a combination thereof may be used.

Additionally, determining the set of parameters includes determining a type of a third material that can be used together with the first material for forming a graded index layer. For example, the graded index layer may be formed from a combination of a third and the first material. For instance, near a surface 121, as shown in FIG. 1A, graded index layer 120 is formed from the third material having an index of refraction $n_3$, and near surface 122, graded index layer 120 is formed from the first material having an index of refraction $n_1$. For example, the third and the first material may be SiN with various molar fractions of silicon and nitrogen. For instance, the first material may have a first molar fraction of silicon and the third material may have a third molar fraction of silicon. In some cases, the first material may be of the form $Si_{a1}N_{b1}$ while the third material may be of the form $Si_{a3}N_{b3}$, where a3 ≠ a2, and b3 ≠ b1. Additionally, or alternatively, other materials can be used for forming the first and the third material. For example, any suitable materials such as TiO2, GaN, AlGaN, AlN, SiO2, MgO, Al2O3, ZnS, ZnO, Ga2O3, BN, InN, InGaN, GaP, Diamond, and combination thereof may be used. Furthermore, determining the set of parameters includes determining not only a type of the third material that can be used together with the first material for forming a graded index layer, but also determining a grading profile for the graded index layer. In some cases, the graded index layer may have a linear grading profile, as shown, for example, in FIG. 2A.

Returning to FIG. 6, control system 610 is configured to determine time dependent mass flow rates m1-mN for releasing the precursor gases, as indicated by arrow 621 in FIG. 6, and selecting a time dependent pressure (as indicated by arrow 622), and a time dependent temperature (as indicated by arrow 623) for the reaction chamber. In some cases, the time dependent temperature can be applied to the substrate holder 642. Further, the control system 610 may be configured to determine a time duration for the deposition of the precursor gases.

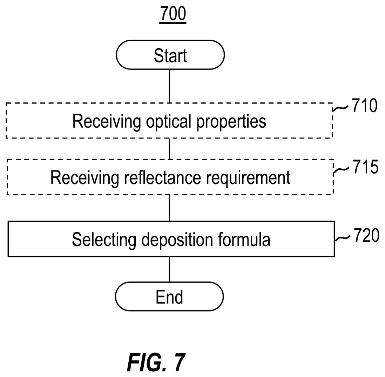

FIG. 7 shows an example of method 700 for selecting a deposition formula for depositing non-dichroic coating thin film on a substrate. Method 700 includes at an optional step 710 receiving optical properties of a substrate, such as a color of substrate, reflectance of a substrate, for example, to visible light in a wavelength range of 400 to 700 nm, scattering light properties of a substrate and the like. These properties may be obtained by a spectrometer. In some cases, in addition to the optical properties mechanical and/or material properties of the substrate may also be obtained. For example, a material from which substrate is fabricated may guide selection of temperature at which the non-dichroic coating thin film can be deposited, and surface properties such as roughness may guide determining how non-dichroic coating thin film will be deposited (e.g., particular temperature and deposition rate profiles as a function of time, as well as thickness of non-dichroic coating thin film).

After completion of step 710, method 700 includes an optional step of receiving reflectance requirements at step 715. The reflectance requirement indicates the amount of light that is expected to be reflected from the non-dichroic coating thin film, as well as the variability of reflectance as a function of wavelength, as described, for example in Table 1, above. In certain instances, the reflectance requirement may include specified ranges for a reflectance coefficient across wavelengths of visible light, typically falling within the range of 400 to 700 nanometers.

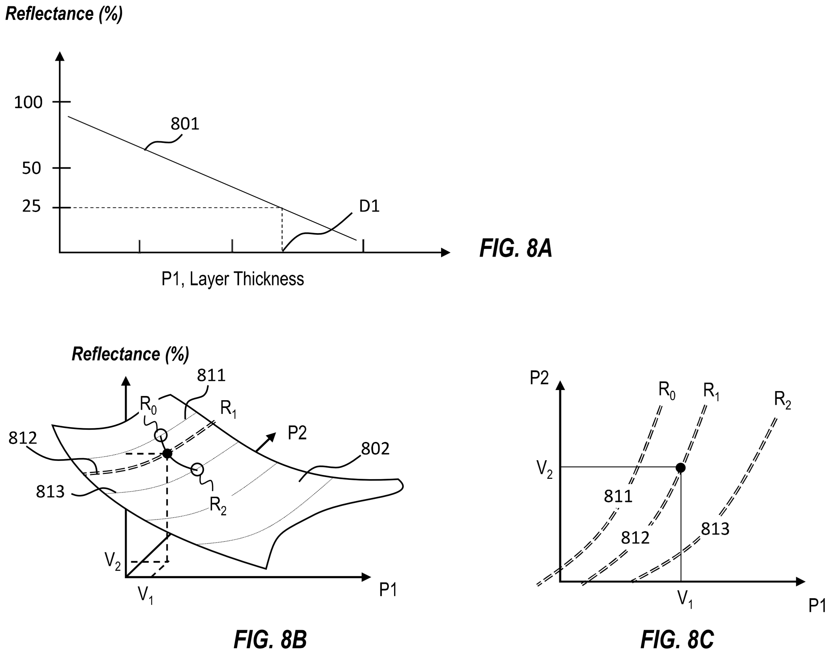

After completion of step 720, a deposition formula may be selected based on the data obtained at steps 710 and 715, and method 700 may be completed. The deposition formula may be selected based on known non-dichroic coating thin films with known reflectance properties when deposited on known substrates of specific optical and/or mechanical properties and having specific surface properties. A database of different non-dichroic coating thin films may be compiled for different substrates having different surface properties which result in specific reflectance characteristics, and based on such a database, a specific formula for non-dichroic coating thin film can be selected. In some cases, when the optical properties of a substrate and/or reflectance requirement do not match exactly the parameters of the database a suitable interpolation approach may be performed to determine the deposition formula. Such interpolation approach is schematically illustrated in FIGS. 8A-8C.

FIG. 8A illustrates an example interpolation approach. In this method, given a reflectance from the non-dichroic coating thin film, a linear function 801 can be employed to determine the thickness of the non-dichroic coating thin film based on the reflectance requirement. For instance, if the reflectance requirement is 25%, a thickness D1 can be utilized. In certain embodiments, thickness D1 may be approximately one micron. FIG. 8A provides an embodiment of interpolation when a single parameter P1 determines the reflective characteristics of the non-dichroic coating thin film.

Typically, however, there exist multiple parameters that can influence the reflective characteristics of the non-dichroic coating thin film. Interpolation in a multi-dimensional parametric space can be conducted, as depicted in FIG. 8B. In FIG. 8B, a surface 802 illustrates the dependence of reflectance on multiple parameters (e.g., parameters P1 and P2). A contour line 812 of constant reflectance is displayed for a required reflectance value R1, as well as contour lines 811 and 813 for reflectance values R0 and R2. FIG. 8C illustrates such contour lines 811-813 for different reflectance values R0-R2. For values V1 and V2 of associated parameters P1 and P2, a specific point on contour line 812 can be selected. This selection may be based on other requirements unrelated to reflectivity, such as the desired thickness, composition, or structure of the non-dichroic coating thin film.

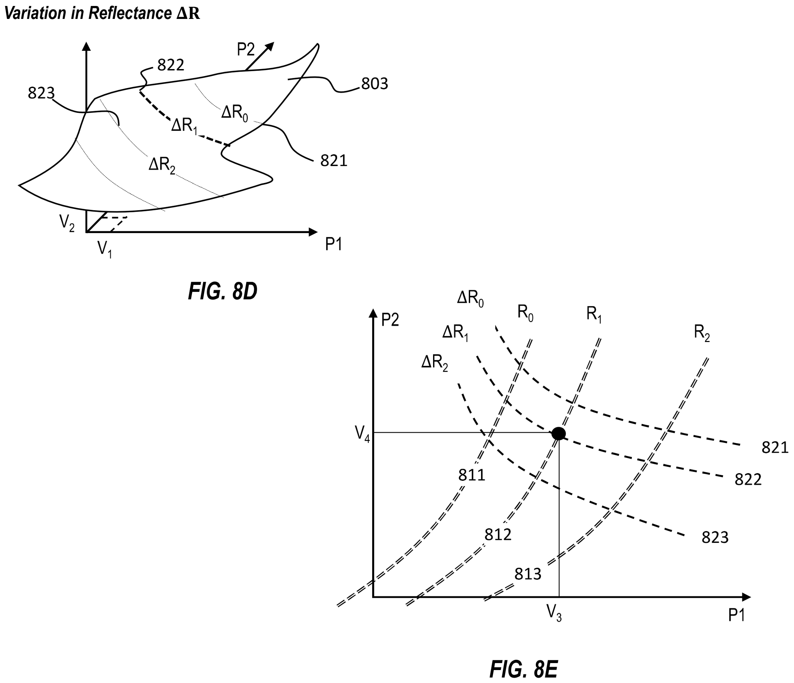

In some cases, such selection may be based on a specific requirement for the variation of reflectance from an average reflectance value as a function of a wavelength of visible light. For example, a surface 803 as shown in FIG. 8D illustrates the dependence of such maximum reflectance variation on multiple parameters (e.g., parameters P1 and P2). A contour line 822 of maximum reflectance variation is displayed for a required maximum variation in reflectance having value $\Delta R1$, as well as similar contour lines 821 and 823 for maximum variation in reflectance having values $\Delta R0$ and $\Delta R2$. FIG. 8E illustrates both contour lines 811-813 for different reflectance values R0-R2, and contour lines 821-823 for different maximum reflectance variations. Note that if values for parameters P1 and P2 need to be selected such that a reflectance of value R1 is desired and a maximum reflectance variation $\Delta R1$ is needed, such parameters can be obtained at the intersection of contour line 822 and 812 and are given by values V3 and V4.

It should be noted that example interpolation approaches described in relation to FIGS. 8A-8E are only illustrative and various other approaches may be used for determining deposition formula based on optical properties of a substrate and reflection requirements. For example, a machine learning model may be implemented that outputs the desired deposition formula based on the input of optical properties of a substrate and reflection requirements. Such a machine learning model may be trained based on historical training data associated with inputs comprising optical properties of a substrate and reflection requirements and desired outputs comprising non-dichroic coating thin film parameters.

When considering machine learning for determining deposition formulas based on the optical properties of a substrate and reflection requirements, various techniques can be applied. One approach is to use regression-based methods, such as linear regression, polynomial regression, or support vector regression. These methods aim to establish a relationship between input features (optical properties of the substrate and reflection requirements) and output parameters (non-dichroic coating thin film parameters).

Additionally, other machine learning techniques can be employed, such as neural networks. Neural networks such as feed forward neural networks (FNNs) are particularly well-suited for complex, non-linear relationships between inputs and outputs. They can learn intricate patterns and correlations within the data, allowing them to potentially capture the nuances of the deposition process more accurately.

Furthermore, ensemble methods, such as random forests or gradient boosting, can also be effective. These techniques combine multiple models to make predictions, which often results in improved performance and robustness. In some cases, hybrid approaches combining different machine learning techniques, such as neural networks and random forests, may be advantageous. These hybrid models can leverage the strengths of each individual method to improve predictive performance further.

Ultimately, the choice of machine learning algorithm depends on factors such as the complexity of the problem, the amount and quality of available data, computational resources, and the desired level of accuracy.

*Implementation example - hardware overview*

According to some embodiments, the techniques described herein, such monitoring deposition of a non-dichroic coating thin film are implemented by at least one computing device. For example, such computing device may be part of control system 610, as shown in FIG. 6, and may include processor 612 and memory 614 for storing instructions that can be executed by processor 612.

The techniques may be implemented in whole or in part using a combination of at least one computer and/or other computing devices that are coupled using a network, such as a packet data network. The computing devices may be hard-wired to perform the techniques, or may include digital electronic devices such as at least one application-specific integrated circuit (ASIC) or field programmable gate array (FPGA) that is persistently programmed to perform the techniques, or may include at least one general purpose hardware processor programmed to perform the techniques pursuant to program instructions in firmware, memory, other storage, or a combination. Such computing devices may also combine custom hard-wired logic, ASICs, or FPGAs with custom programming to accomplish the described techniques. The computing devices may be server computers, workstations, personal computers, portable computer systems, handheld devices, mobile computing devices, smartphones, internetworking devices, autonomous or semi-autonomous devices or any other electronic device that incorporates hard-wired and/or program logic to implement the described techniques, one or more virtual computing machines or instances in a data center, and/or a network of server computers and/or personal computers.

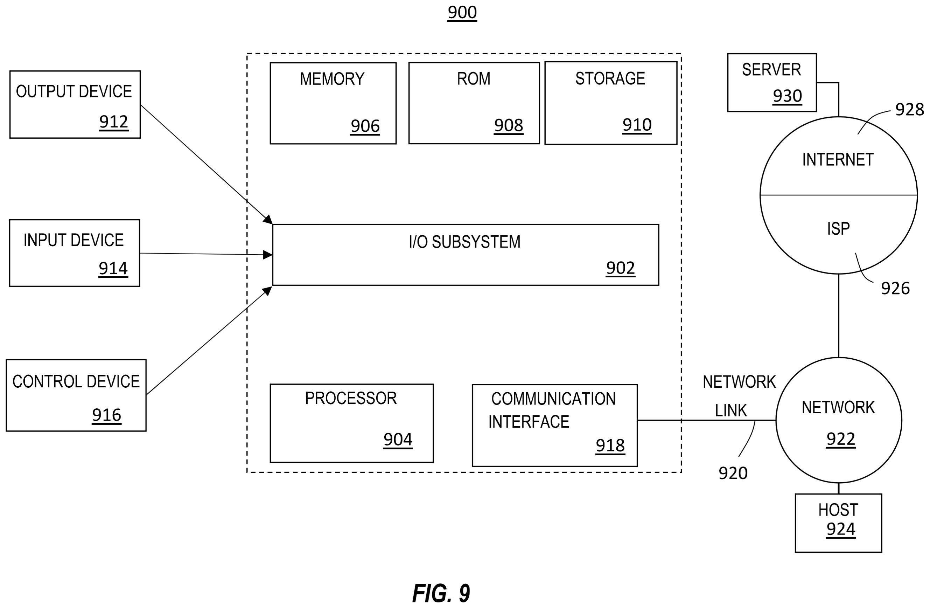

FIG. 9 is a block diagram that illustrates an example computer system with which an embodiment may be implemented. In the example of FIG. 9, a computer system 900 and instructions for implementing the disclosed technologies in hardware, software, or a combination of hardware and software, are represented schematically, for example as boxes and circles, at the same level of detail that is commonly used by persons of ordinary skill in the art to which this disclosure pertains for communicating about computer architecture and computer systems implementations.

Computer system 900 includes an input/output (I/O) subsystem 902 which may include a bus and/or other communication mechanism(s) for communicating information and/or instructions between the components of the computer system 900 over electronic signal paths. I/O subsystem 902 may include an I/O controller, a memory controller and at least one I/O port. The electronic signal paths are represented schematically in the drawings, for example as lines, unidirectional arrows, or bidirectional arrows.

At least one hardware processor 904 is coupled to I/O subsystem 902 for processing information and instructions. Hardware processor 904 may include, for example, a general-purpose microprocessor or microcontroller and/or a special-purpose microprocessor such as an embedded system or a graphics processing unit (GPU) or a digital signal processor or ARM processor. Processor 904 may comprise an integrated arithmetic logic unit (ALU) or may be coupled to a separate ALU.

Computer system 900 includes one or more units of memory 906, such as a main memory, which is coupled to I/O subsystem 902 for electronically digitally storing data and instructions to be executed by processor 904. Memory 906 may include volatile memory such as various forms of random-access memory (RAM) or other dynamic storage device. Memory 906 also may be used for storing temporary variables or other intermediate information during execution of instructions to be executed by processor 904. Such instructions, when stored in non-transitory computer-readable storage media accessible to processor 904, can render computer system 900 into a special-purpose machine that is customized to perform the operations specified in the instructions.

Computer system 900 further includes non-volatile memory such as read only memory (ROM) 908 or another static storage device coupled to I/O subsystem 902 for storing information and instructions for processor 904. ROM 908 may include various forms of programmable ROM (PROM) such as erasable PROM (EPROM) or electrically erasable PROM (EEPROM). A unit of persistent storage 910 may include various forms of non-volatile RAM (NVRAM), such as FLASH memory, solid-state storage, magnetic disk, or optical disk such as CD-ROM or DVD-ROM and may be coupled to I/O subsystem 902 for storing information and instructions. Storage 910 is an example of a non-transitory computer-readable medium that may be used to store instructions and data which when executed by the processor 904 cause performing computer-implemented methods to execute the techniques herein.

The instructions in memory 906, ROM 908, or storage 910 may comprise one or more sets of instructions that are organized as modules, methods, objects, functions, routines, or calls. The instructions may be organized as one or more computer programs, operating system services, or application programs including mobile apps. The instructions may comprise an operating system and/or system software; one or more libraries to support multimedia, programming, or other functions; data protocol instructions or stacks to implement TCP/IP, HTTP, or other communication protocols; file format processing instructions to parse or render files coded using HTML, XML, JPEG, MPEG or PNG; user interface instructions to render or interpret commands for a graphical user interface (GUI), command-line interface or text user interface; application software such as an office suite, internet access applications, design and manufacturing applications, graphics applications, audio applications, software engineering applications, educational applications, games or miscellaneous applications. The instructions may implement a web server, web application server or web client. The instructions may be organized as a presentation layer, application layer, and data storage layer such as a relational database system using structured query language (SQL) or no SQL, an object store, a graph database, a flat file system or other data storage.

Computer system 900 may be coupled via I/O subsystem 902 to at least one output device 912. In one embodiment, output device 912 is a digital computer display. Examples of a display that may be used in various embodiments include a touch screen display or a light-emitting diode (LED) display or a liquid crystal display (LCD) or an e-paper display. Computer system 900 may include other type(s) of output devices 912, alternatively or in addition to a display device. Examples of other output devices 912 include printers, ticket printers, plotters, projectors, sound cards or video cards, speakers, buzzers or piezoelectric devices or other audible devices, lamps or LED or LCD indicators, haptic devices, actuators, or servos.

At least one input device 914 is coupled to I/O subsystem 902 for communicating signals, data, command selections or gestures to processor 904. Examples of input devices 914 include touch screens, microphones, still and video digital cameras, alphanumeric and other keys, keypads, keyboards, graphics tablets, image scanners, joysticks, clocks, switches, buttons, dials, slides, and/or various types of sensors such as force sensors, motion sensors, heat sensors, accelerometers, gyroscopes, and inertial measurement unit (IMU) sensors and/or various types of transceivers such as wireless, such as cellular or Wi-Fi, radio frequency (RF) or infrared (IR) transceivers and Global Positioning System (GPS) transceivers.

Another type of input device is a control device 916, which may perform cursor control or other automated control functions such as navigation in a graphical interface on a display screen, alternatively or in addition to input functions. Control device 916 may be a touchpad, a mouse, a trackball, or cursor direction keys for communicating direction information and command selections to processor 904 and for controlling cursor movement on output device 912. Control device 916 may have at least two degrees of freedom in two axes, a first axis (e.g., x) and a second axis (e.g., y), that allows the device to specify positions in a plane. Another type of input device may be a wired, wireless, or optical control device such as a joystick, wand, console, steering wheel, pedal, gearshift mechanism or other type of control device. Input device 914 may include a combination of multiple different input devices, such as a video camera and a depth sensor.

In another embodiment, computer system 900 may comprise an internet of things (IoT) device in which one or more of the output device 912, input device 914, and control device 916 are omitted. Or, in such an embodiment, the input device 914 may comprise one or more cameras, motion detectors, thermometers, microphones, seismic detectors, other sensors or detectors, measurement devices or encoders and the output device 912 may comprise a special-purpose display such as a single-line LED or LCD display, one or more indicators, a display panel, a meter, a valve, a solenoid, an actuator or a servo.

When computer system 900 is a mobile computing device, input device 914 may comprise a global positioning system (GPS) receiver coupled to a GPS module that is capable of triangulating to a plurality of GPS satellites, determining and generating geo-location or position data such as latitude-longitude values for a geophysical location of the computer system 900. Output device 912 may include hardware, software, firmware, and interfaces for generating position reporting packets, notifications, pulse or heartbeat signals, or other recurring data transmissions that specify a position of the computer system 900, alone or in combination with other application-specific data, directed toward host 924 or server 930.

Computer system 900 may implement the techniques described herein using customized hard-wired logic, at least one ASIC or FPGA, firmware and/or program instructions or logic which when loaded and used or executed in combination with the computer system causes or programs the computer system to operate as a special-purpose machine. According to one embodiment, the techniques herein are performed by computer system 900 in response to processor 904 executing at least one sequence of at least one instruction contained in main memory 906. Such instructions may be read into main memory 906 from another storage medium, such as storage 910. Execution of the sequences of instructions contained in main memory 906 causes processor 904 to perform the process steps described herein. In alternative embodiments, hard-wired circuitry may be used in place of or in combination with software instructions.

The term "storage media" as used herein refers to any non-transitory media that store data and/or instructions that cause a machine to operation in a specific fashion. Such storage media may comprise non-volatile media and/or volatile media. Non-volatile media includes, for example, optical or magnetic disks, such as storage 910. Volatile media includes dynamic memory, such as memory 906. Common forms of storage media include, for example, a hard disk, solid state drive, flash drive, magnetic data storage medium, any optical or physical data storage medium, memory chip, or the like.

Storage media is distinct from but may be used in conjunction with transmission media. Transmission media participates in transferring information between storage media. For example, transmission media includes coaxial cables, copper wire, and fiber optics, including the wires that comprise a bus of I/O subsystem 902. Transmission media can also take the form of acoustic or light waves, such as those generated during radio-wave and infra-red data communications.

Various forms of media may be involved in carrying at least one sequence of at least one instruction to processor 904 for execution. For example, the instructions may initially be carried on a magnetic disk or solid-state drive of a remote computer. The remote computer can load the instructions into its dynamic memory and send the instructions over a communication link such as a fiber optic or coaxial cable or telephone line using a modem. A modem or router local to computer system 900 can receive the data on the communication link and convert the data to a format that can be read by computer system 900. For instance, a receiver such as a radio frequency antenna or an infrared detector can receive the data carried in a wireless or optical signal and appropriate circuitry can provide the data to I/O subsystem 902 such as place the data on a bus. I/O subsystem 902 carries the data to memory 906, from which processor 904 retrieves and executes the instructions. The instructions received by memory 906 may optionally be stored on storage 910 either before or after execution by processor 904.

Computer system 900 also includes a communication interface 918 coupled to I/O subsystem 902. Communication interface 918 provides a two-way data communication coupling to network link(s) 920 that are directly or indirectly connected to at least one communication networks, such as a network 922 or a public or private cloud on the Internet. For example, communication interface 918 may be an Ethernet networking interface, integrated-services digital network (ISDN) card, cable modem, satellite modem, or a modem to provide a data communication connection to a corresponding type of communications line, for example an Ethernet cable or a metal cable of any kind or a fiber-optic line or a telephone line. Network 922 broadly represents a local area network (LAN), wide-area network (WAN), campus network, internetwork, or any combination thereof. Communication interface 918 may comprise a LAN card to provide a data communication connection to a compatible LAN, or a cellular radiotelephone interface that is wired to send or receive cellular data according to cellular radiotelephone wireless networking standards, or a satellite radio interface that is wired to send or receive digital data according to satellite wireless networking standards. In any such implementation, communication interface 918 sends and receives electrical, electromagnetic, or optical signals over signal paths that carry digital data streams representing various types of information.

Network link 920 typically provides electrical, electromagnetic, or optical data communication directly or through at least one network to other data devices, using, for example, satellite, cellular, Wi-Fi, or BLUETOOTH technology. For example, network link 920 may provide a connection through network 922 to host 924.

Furthermore, network link 920 may provide a connection through network 922 or to other computing devices via internetworking devices and/or computers that are operated by an Internet Service Provider (ISP) 926. ISP 926 provides data communication services through a world-wide packet data communication network represented as internet 928. A server 930 may be coupled to internet 928. Server 930 broadly represents any computer, data center, virtual machine, or virtual computing instance. Server 930 may represent an electronic digital service that is implemented using more than one computer or instance and that is accessed and used by transmitting web services requests, uniform resource locator (URL) strings with parameters in HTTP payloads, API calls, app services calls, or other service calls. Computer system 900 and server 930 may form elements of a distributed computing system that includes other computers, a processing cluster, server farm or other organization of computers that cooperate to perform tasks or execute applications or services. Server 930 may comprise one or more sets of instructions that are organized as modules, methods, objects, functions, routines, or calls. The instructions may be organized as one or more computer programs, operating system services, or application programs including mobile apps. The instructions may comprise an operating system and/or system software; one or more libraries to support multimedia, programming or other functions; data protocol instructions or stacks to implement TCP/IP, HTTP or other communication protocols; file format processing instructions to parse or render files coded using HTML, XML, JPEG, MPEG or PNG; user interface instructions to render or interpret commands for a graphical user interface (GUI), command-line interface or text user interface; application software such as an office suite, internet access applications, design and manufacturing applications, graphics applications, audio applications, software engineering applications, educational applications, games or miscellaneous applications. Server 930 may comprise a web application server that hosts a presentation layer, application layer and data storage layer such as a relational database system using structured query language (SQL) or no SQL, an object store, a graph database, a flat file system or other data storage.

Computer system 900 can send messages and receive data and instructions, including program code, through the network(s), network link 920 and communication interface 918. In the Internet example, a server 930 might transmit a requested code for an application program through Internet 928, ISP 926, network 922 and communication interface 918. The received code may be executed by processor 904 as it is received, and/or stored in storage 910, or other non-volatile storage for later execution.

The execution of instructions as described in this section may implement a process in the form of an instance of a computer program that is being executed and consisting of program code and its current activity. Depending on the operating system (OS), a process may be made up of multiple threads of execution that execute instructions concurrently. In this context, a computer program is a passive collection of instructions, while a process may be the actual execution of those instructions. Several processes may be associated with the same program; for example, opening several instances of the same program often means more than one process is being executed. Multitasking may be implemented to allow multiple processes to share processor 904. While each processor 904 or core of the processor executes a single task at a time, computer system 900 may be programmed to implement multitasking to allow each processor to switch between tasks that are being executed without having to wait for each task to finish. In an embodiment, switches may be performed when tasks perform input/output operations, when a task indicates that it can be switched, or on hardware interrupts. Time-sharing may be implemented to allow fast response for interactive user applications by rapidly performing context switches to provide the appearance of concurrent execution of multiple processes simultaneously. In an embodiment, for security and reliability, an operating system may prevent direct communication between independent processes, providing strictly mediated and controlled inter-process communication functionality.

In the foregoing specification, embodiments of the present disclosure have been described with reference to numerous specific details that may vary from implementation to implementation. The specification and drawings are, accordingly, to be regarded in an illustrative rather than a restrictive sense. The sole and exclusive indicator of the scope of the present disclosure, and what is intended by the applicants to be the scope of the present disclosure, is the literal and equivalent scope of the set of claims that issue from this application, in the specific form in which such claims issue, including any subsequent correction.

The scope of this disclosure encompasses all changes, substitutions, variations, alterations, and modifications to the example embodiments described or illustrated herein that a person having ordinary skill in the art would comprehend. The scope of this disclosure is not limited to the example embodiments described or illustrated herein. Moreover, although this disclosure describes and illustrates respective embodiments herein as including particular components, elements, feature, functions, operations, or steps, any of these embodiments may include any combination or permutation of any of the components, elements, features, functions, operations, or steps described or illustrated anywhere herein that a person having ordinary skill in the art would comprehend. Furthermore, reference in the appended claims to an apparatus or system or a component of an apparatus or system being adapted to, arranged to, capable of, configured to, enabled to, operable to, or operative to perform a particular function encompasses that apparatus, system, component, whether or not it or that particular function is activated, turned on, or unlocked, as long as that apparatus, system, or component is so adapted, arranged, capable, configured, enabled, operable, or operative. Additionally, although this disclosure describes or illustrates particular embodiments as providing particular advantages, particular embodiments may provide none, some, or all of these advantages.

Herein, "or" is inclusive and not exclusive, unless expressly indicated otherwise or indicated otherwise by context. Therefore, herein, "A or B" means "A, B, or both," unless expressly indicated otherwise or indicated otherwise by context. Moreover, "and" is both joint and several, unless expressly indicated otherwise or indicated otherwise by context. Therefore, herein, "A and B" means "A and B, jointly or severally," unless expressly indicated otherwise or indicated otherwise by context.

**Claims**

1. A non-dichroic coating thin film structure deposited over a substrate, the non-dichroic coating thin film structure comprising:

   a Bragg-reflector structure deposited over the substrate and having a plurality of pairs of layers, each pair having a first layer and a second layer;
   the first layer comprising a first material of a first refractive index and having a first thickness of a quarter of a target wavelength determined within the first layer, the first layer positioned adjacent to the second layer;
   the second layer comprising a second material of a second refractive index and having a second thickness of the quarter of the target wavelength determined within the second layer, wherein the first refractive index is at least 0.5 higher than the second refractive index; and
   a graded index layer of a continuously changing graded refractive index deposited over the Bragg-reflector structure, wherein the graded refractive index changes continuously from a third refractive index to the first refractive index, and wherein a thickness of the graded index layer is selected such that a reflection coefficient for a light of a visible wavelength varies by no more than 25 percent for a visible wavelength range of 400-700 nanometers.

2. The non-dichroic coating thin film structure of claim 1, wherein the target wavelength is determined based on a color of the substrate, and,
   optionally, the target wavelength corresponds to a color that is complementary to the color of the substrate.

3. The non-dichroic coating thin film structure of claim 1 or claim 2, wherein the first refractive index is in a range between 2.5 and 3.5.

4. The non-dichroic coating thin film structure of any one of the preceding claims, wherein the second refractive index is in a range between 1.5 and 2.5.

5. The non-dichroic coating thin film structure of any one of the preceding claims, wherein the third refractive index is in a range between 1.5 and 2.5.

6. The non-dichroic coating thin film structure of any one of the preceding claims, wherein the graded index layer:

(a) is selected from a composite material comprising variable molar fractions of silicon and nitrogen; and/or
(b) comprises a silicon nitride layer is deposited using a chemical vapor deposition, and wherein variable molar fractions of silicon and nitrogen are determined by a mass flow rate of silane and ammonia gases, optionally wherein the chemical vapor deposition is plasma enhanced to reduce a substrate temperature to a few hundred degrees of Celsius.

7. The non-dichroic coating thin film structure of any one of the preceding claims, wherein the thickness of the Bragg-reflector structure is about one and a half micron and wherein the thickness of the graded index layer is further determined based on a reflectivity requirement of the non-dichroic coating thin film structure.

8. The non-dichroic coating thin film structure of any one of the preceding claims:

(a) having a reflectivity of more than ten percent; and/or
(b) wherein the graded refractive index has a linear profile.

9. The non-dichroic coating thin film structure of any one of the preceding claims, wherein the Bragg-reflector layer is a first Bragg-reflector layer, the non-dichroic coating thin film structure further comprising a second Bragg-reflector layer deposited between the substrate and the first Bragg-reflector layer, the second Bragg-reflector layer configured to reflect a light at a second target wavelength that is different than the target wavelength of the first Bragg-reflector layer by at least a hundred of nanometers.

10. The non-dichroic coating thin film structure of any one of the preceding claims, wherein a composition of the graded index layer is selected such that it is about fifty percent reflective at the thickness of about 0.1 microns.

11. A system for depositing a non-dichroic coating thin film, the system comprising a control system having a processor for executing instructions that cause, the control system to transmit signals to operate mass flow controllers for a deposition of precursor gases, and for maintaining a temperature and pressure control within a reaction chamber, the instructions causing the processor to perform operations comprising:

receiving optical properties of a substrate including a color of the substrate obtained from spectrophotometer measurements;
receiving a reflectance requirement for the substrate;
based on the received optical properties and the reflectance requirement, selecting a formula for the deposition of the non-dichroic coating thin film over the substrate, wherein the selecting of the formula comprises determining a set of parameters for the non-dichroic coating thin film, the non-dichroic coating thin film comprising:

a Bragg-reflector structure deposited over the substrate and having a plurality of pairs of layers, each pair having a first layer and a second layer;
the first layer comprising a first material of a first refractive index and having a first thickness of a quarter of a target wavelength determined within the first layer, the first layer adjacent to the second layer;
the second layer comprising a second material of a second refractive index and having a second thickness of the quarter of the target wavelength determined within the second layer, wherein the first refractive index is at least 0.5 higher than the second refractive index;
a graded index layer of a continuously changing graded refractive index deposited over the Bragg-reflector structure, wherein the graded refractive index changes continuously from a third refractive index to the first refractive index; and

wherein the determining the set of parameters comprises:

determining the target wavelength; and
determining a thickness of the graded index layer.

12. The system of claim 11, wherein the determining the set of parameters:

(a) further comprises determining the first and the second material; and/or
(b) comprises determining a third material having the third refractive index and determining a grading profile for

17

the graded index layer.

13. The system of claim 11 or claim 12, wherein the determining the set of parameters includes:

(a) determining time dependent mass flow rates for releasing the precursor gases and selecting time dependent pressure and temperature for the reaction chamber; and/or
(b) determining a time duration for the deposition of the precursor gases.

14. The system of any one of claims 11 to 13, wherein the reflectance requirement comprises required ranges for a reflectance coefficient for a set of wavelengths in a range of 400 to 700 nanometers.

15. The system any one of claims 11 to 14, wherein the optical properties of the substrate comprise reflectance of the substrate to visible light in a range of 400 to 700 nanometers and scattering of the visible light from the substrate.

**FIG. 1A**

**FIG. 1B**

**FIG. 2A**

**FIG. 2B**

*FIG. 3*

EP 4 733 817 A1

**FIG. 4**

NITRIDATION vs RATE vs TIME IN MINUTES

NITROGEN PERCENT

ANGSTROMS PER SECOND

510

520

MINUTES

- - - RATE ANGSTROMS/SECOND

—— NITRIDATION PERCENT

*FIG. 5*

m1, m2, ... mN

621

630

632

610 Control System

P

622

612 Processor

634

614 Memory

636

640

642

623

T

**FIG. 6**

EP 4 733 817 A1

EP 4 733 817 A1

<u>700</u>

```
   ┌─────────┐
   │  Start  │
   └─────────┘
        │
┌- - - - - - - - - - - - - - - - - - -┐
│    Receiving optical properties      │ ~ 710
└- - - - - - - - - - - - - - - - - - -┘
        │
┌- - - - - - - - - - - - - - - - - - -┐
│  Receiving reflectance requirement   │ ~ 715
└- - - - - - - - - - - - - - - - - - -┘
        │
┌─────────────────────────────────────┐
│      Selecting deposition formula    │ ~ 720
└─────────────────────────────────────┘
        │
   ┌─────────┐
   │   End   │
   └─────────┘
```

*FIG. 7*

EP 4 733 817 A1

Reflectance (%)

100

50

25

801

D1

P1, Layer Thickness

*FIG. 8A*

Reflectance (%)

811

$R_0$

$R_1$

812

P2

802

813

$R_2$

$V_2$

$V_1$

P1

*FIG. 8B*

P2

$R_0$

$R_1$

$R_2$

$V_2$

811

812

813

$V_1$

P1

*FIG. 8C*

*FIG. 8D*

*FIG. 8E*

FIG. 9

Europäisches
Patentamt

European
Patent Office

Office européen
des brevets

# EUROPEAN SEARCH REPORT

**Application Number**

EP 25 20 9220

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/324179 A1 (THYAGARAJAN KRISHNAN [US] ET AL) 24 October 2019 (2019-10-24) * paragraphs [0014], [0038] - [0067]; figures 3,4B,5A,5B,10 * | 1-15 | INV. G02B5/08 G02B5/28 C23C14/06 C23C14/54 |
| Y | US 2022/221786 A1 (XIAO WEN [SG] ET AL) 14 July 2022 (2022-07-14) * paragraphs [0075] - [0079]; figures 2A,2B * | 1-15 | |
| A | US 2019/019976 A1 (KIM NAM-KOOK [KR] ET AL) 17 January 2019 (2019-01-17) * paragraphs [0062], [0082] - [0085] * | 6,13 | |
| A | QIU WEIBIN ET AL: "Quasicontinuous refractive index tailoring of SiNx and SiOxNy for broadband antireflective coatings", APPLIED PHYSICS LETTERS AMERICAN INSTITUTE OF PHYSICS, 2 HUNTINGTON QUADRANGLE, MELVILLE, NY 11747, vol. 96, no. 14, 9 April 2010 (2010-04-09) , pages 141116-141116, XP012130676, ISSN: 0003-6951, DOI: 10.1063/1.3380825 [retrieved on 2010-04-09] * page 1, column 2, paragraph 6-7 * | 6,13 | |
| A | US 2001/016262 A1 (TOYOSHIMA TAKAYUKI [JP] ET AL) 23 August 2001 (2001-08-23) * paragraph [0022]; figure 2 * | 8 | |
| A | US 2014/191264 A1 (KIM JUNG-SUB [US] ET AL) 10 July 2014 (2014-07-10) * paragraph [0092]; figure 6B * | 8 | |
| A | CN 104 678 469 B (SHANGHAI ADVANCED RES INST CAS) 2 November 2018 (2018-11-02) * the whole document * | 1-15 | |

**TECHNICAL FIELDS SEARCHED (IPC)**

G02B
C23C
C03C

The present search report has been drawn up for all claims

| Place of search | Date of completion of the search | Examiner |
|---|---|---|
| Munich | 18 March 2026 | Knorn, Raphaela |

EPO FORM 1503 03.82 (P04C01)

## ANNEX TO THE EUROPEAN SEARCH REPORT
## ON EUROPEAN PATENT APPLICATION NO.

EP 25 20 9220

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2026

| Patent document cited in search report | | Publication date | Patent family member(s) | | Publication date |
|---|---|---|---|---|---|
| US 2019324179 | A1 | 24-10-2019 | CN | 110398798 A | 01-11-2019 |
| | | | EP | 3561556 A1 | 30-10-2019 |
| | | | US | 2019324179 A1 | 24-10-2019 |
| US 2022221786 | A1 | 14-07-2022 | JP | 2022528988 A | 16-06-2022 |
| | | | KR | 20210143937 A | 29-11-2021 |
| | | | SG | 11202110430V A | 29-11-2021 |
| | | | TW | 202104957 A | 01-02-2021 |
| | | | US | 2020333700 A1 | 22-10-2020 |
| | | | US | 2022221786 A1 | 14-07-2022 |
| | | | WO | 2020214909 A1 | 22-10-2020 |
| US 2019019976 | A1 | 17-01-2019 | CN | 109244253 A | 18-01-2019 |
| | | | KR | 20190006834 A | 21-01-2019 |
| | | | US | 2019019976 A1 | 17-01-2019 |
| US 2001016262 | A1 | 23-08-2001 | DE | 10100221 A1 | 12-07-2001 |
| | | | JP | 2001192821 A | 17-07-2001 |
| | | | US | 2001016262 A1 | 23-08-2001 |
| US 2014191264 | A1 | 10-07-2014 | KR | 20140090346 A | 17-07-2014 |
| | | | US | 2014191264 A1 | 10-07-2014 |
| CN 104678469 | B | 02-11-2018 | NONE | | |

EPO FORM P0459

For more details about this annex : see Official Journal of the European Patent Office, No. 12/82